# EUROPÄISCHE PATENTANMELDUNG

(11) **EP 2 182 637 A1**
(43) Veröffentlichungstag der Anmeldung: **05.05.2010**
(21) Anmeldenummer: 09013512.0
(22) Anmeldetag: 27.10.2009
(51) Int. Cl.: H03K 19/00

(54) **Schaltung, Verfahren zur Steuerung und Verwendung einer Schaltung für einen Ruhemodus und einen Betriebsmodus**

(30) Priorität: 28.10.2008 DE 102008053533
(71) Anmelder: Atmel Automotive GmbH, 74072 Heilbronn (DE)
(72) Erfinder: Dathe, Lutz, 01109 Dresden (DE); Hanusch, Thomas, 01640 Coswig (DE); Vorwek, Matthias, Dipl.-Ing., 01129 Dresden (DE)
(74) Vertreter: Müller, Wolf-Christian

(57) **Zusammenfassung**

Schaltung (10), Verfahren zur Steuerung und Verwendung einer Schaltung (10) für einen Ruhemodus und einen Betriebsmodus
- mit einem digitalen CMOS-Schaltkreis (20) mit NMOS-Feldeffekttransistoren (MN21, MN22, MN23, MN24) und mit PMOS-Feldeffekttransistoren (MP21, MP22, MP23, MP24),
- mit einer ersten Lastvorrichtung (40), wobei Source-Anschlüsse (S) der NMOS-Feldeffekttransistoren (MN21, MN22, MN23, MN24) des digitalen CMOS-Schaltkreises (20) über die erste Lastvorrichtung (40) mit einer ersten Versorgungsspannung (VSS) verbunden sind, und
- mit einer zweiten Lastvorrichtung (30), wobei Source-Anschlüsse (S) der PMOS-Feldeffekttransistoren (MP21, MP22, MP23, MP24) des digitalen CMOS-Schaltkreises (20) über die zweite Lastvorrichtung (30) mit einer zweiten Versorgungsspannung (VDD) verbunden sind,
- bei der Body-Anschlüsse (B) der NMOS-Feldeffekttransistoren (MN21, MN22, MN23, MN24) des digitalen CMOS-Schaltkreises (20) unmittelbar mit der ersten Versorgungsspannung (VSS) verbunden sind,
- bei der Body-Anschlüsse (B) der PMOS-Feldeffekttransistoren (MP21, MP22, MP23, MP24) des digitalen CMOS-Schaltkreises (20) unmittelbar mit der zweiten Versorgungsspannung (VDD) verbunden sind.

## Beschreibung

Die vorliegende Erfindung betrifft eine Schaltung, ein Verfahren zur Steuerung und eine Verwendung einer Schaltung für einen Ruhemodus und einen Betriebsmodus.

Verschiedene Schaltungen ermöglichen einen Betrieb in zumindest einem Ruhemodus und in zumindest einem Betriebsmodus. In dem Ruhemodus ist der Stromverbrauch der Schaltung gegenüber dem Betriebsmodus reduziert. Hierzu werden Steuer-Schaltungen verwendet, die einen digitalen Schaltkreis aktivieren beziehungsweise deaktivieren und in den Ruhemodus und in den Betriebsmodus schalten können. Wird ein Schaltkreis für die Abarbeitung einer Funktion benötigt, wird dieser von einem Ruhemodus in einen für die Funktion zugehörigen Betriebsmodus versetzt.

Der Erfindung liegt die Aufgabe zugrunde, eine Schaltung mit möglichst verbesserten Eigenschaften für einen Ruhemodus anzugeben.

Diese Aufgabe wird durch die Schaltung mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist eine Schaltung vorgesehen. Vorzugsweise ist die Schaltung auf einem Halbleiter-Chip monolithisch integriert. Die integrierte Schaltung weist einen digitalen CMOS-Schaltkreis mit NMOS-Feldeffekttransistoren und mit PMOS-Feldeffekttransistoren auf. MOS-Feldeffekttransistoren (MOS: engl. Metal-Oxide Semiconductor) weisen eine Source (Quelle), einen Drain (Senke) ein Gate (Tor) und einen Body (Wanne/Substrat), der auch als Bulk bezeichnet wird, auf. NMOS-Feldeffekttransistoren sind dabei vom n-leitenden Typ, während PMOS-Feldeffekttransistoren vom p-leitenden Typ sind. In dem digitalen CMOS-Schaltkreis werden die NMOS-Feldeffekttransistoren und PMOS-Feldeffekttransistoren als komplementäre Typen verwendet. Dabei ist in einer logischen Grundfunktion, wie beispielsweise einem Gatter, jedem NMOS-Feldeffekttransistor zumindest ein PMOS-Feldeffekttransistor und jedem PMOS-Feldeffekttransistor zumindest ein NMOS-Feldeffekttransistor zugeordnet.

Die Schaltung weist eine erste Lastvorrichtung und eine zweite Lastvorrichtung auf. Die erste Lastvorrichtung ist mit einer ersten Versorgungsspannung und mit den Source-Anschlüssen der NMOS-Feldeffekttransistoren des digitalen CMOS-Schaltkreises verbunden. Die zweite Lastvorrichtung ist mit einer zweiten Versorgungsspannung und mit den Source-Anschlüssen der PMOS-Feldeffekttransistoren des digitalen CMOS-Schaltkreises verbunden. Unter einer Lastvorrichtung ist dabei ein Schaltungsbestandteil zu verstehen, der für einen durch diesen fließenden Strom eine Last darstellt und einen Spannungsabfall über der Last bewirkt. Vorzugsweise weist die Lastvorrichtung dabei eine Stromspannungskennlinie auf, die einem linearen oder nichtlinearen Verlauf zugeordnet ist.

Body-Anschlüsse der NMOS-Feldeffekttransistoren des digitalen CMOS-Schaltkreises sind unmittelbar mit der ersten Versorgungsspannung (leitend) verbunden. Demzufolge ist zwischen den Body-Anschlüssen der NMOS-Feldeffekttransistoren und der ersten Versorgungsspannung kein Bauelement, insbesondere kein Bauelement mit einem Widerstand vorgesehen. Beispielsweise sind die Body-Anschlüsse der NMOS-Feldeffekttransistoren mit der Versorgungsspannung über einen Leiter, insbesondere einen metallischen Leiter, verbunden: Das gleiche gilt für die Body-Anschlüsse der PMOS-Transistoren des digitalen CMOS-Schaltkreises, die unmittelbar mit der zweiten Versorgungsspannung verbunden sind.

Der Erfindung liegt weiterhin die Aufgabe zugrunde ein möglichst verbessertes Verfahren zur Steuerung einer Schaltung anzugeben. Diese Aufgabe wird durch das Verfahren mit den Merkmalen des unabhängigen Anspruchs 11 gelöst. Vorteilhafte Weiterbildungen sind Gegenstand von abhängigen Ansprüchen und in der Beschreibung enthalten.

Demzufolge ist ein Verfahren für eine Schaltung mit MOS-Feldeffekttransistoren zur Steuerung derselben in einem Betriebsmodus und in einem Ruhemodus mit gegenüber dem Betriebsmodus reduziertem Stromverbrauch vorgesehen. Dabei können auch mehrere Ruhemodi und/oder mehrere Betriebsmodi vorgesehen sein. In dem Betriebsmodus wird eine mit Source-Anschlüssen der MOS-Feldeffekttransistoren verbundene Lastvorrichtung in einen nieder-ohmigen Zustand gesteuert. In dem nieder-ohmigen Zustand ist dabei ein Spannungsabfall über der Lastvorrichtung bezüglich der Funktion der Schaltung zu vernachlässigen. Beispielsweise wird die Steuerung des nieder-ohmigen Zustands durch ein Einschalten eines Schalttransistors bewirkt.

In dem Ruhemodus wird die Lastvorrichtung in einen Zustand mit gegenüber dem Betriebsmodus höheren Widerstandswert gesteuert. Die Lastvorrichtung wird dabei derart gesteuert, dass ein im Ruhemodus durch die MOS-Feldeffekttransistoren und durch die Lastvorrichtung fließender Leckstrom einen Spannungsabfall über der Lastvorrichtung erzeugt.

Der Erfindung liegt weiterhin die Aufgabe zugrunde, eine Verwendung einer Schaltung für einen Ruhemodus und einen Betriebsmodus anzugeben.

Diese Aufgabe wird durch eine Verwendung mit den Merkmalen des unabhängigen Anspruchs 12 gelöst. Vorteilhafte Weiterbildungen sind Gegenstand von abhängigen Ansprüchen und in der Beschreibung angegeben.

Demzufolge ist eine Verwendung einer Lastvorrichtung zur Erzeugung einer Body-Source-Spannung an MOS-Feldeffekttransistoren einer Schaltung. Hierzu ist die Lastvorrichtung mit Source-Anschlüssen der MOS-Transistoren der Schaltung verbunden. Die Body-Source-Spannung wird in einem Ruhemodus der Schaltung erzeugt. Ein durch die MOS-Feldeffekttransistoren und durch die Lastvorrichtung fließender Leckstrom bewirkt einen Spannungsabfall an der Lastvorrichtung. Dieser Spannungsabfall erzeugt aufgrund der Verbindungen der Lastvorrichtung mit den MOS-Feldeffekttransistoren eine Body-Source-Spannung an den Source- und Body-Anschlüssen der MOS-Feldeffekttransistoren. Bevorzugt fließt insbesondere in einem Ruhemodus ausschließlich der Leckstrom durch die Lastvorrichtung. Bevorzugt wird der Spannungsabfall an der Lastvorrichtung ausschließlich durch den Leckstrom erzeugt.

In einem weiteren Aspekt der Erfindung ist eine Verwendung einer Schaltung für einen Ruhemodus und ein Betriebsmodus vorgesehen. Die Schaltung weist eine Anzahl von MOS-Feldeffekttransistoren auf, deren Body-Anschlüsse mit einer Versorgungsspannung verbunden sind.

Die Schaltung weist weiterhin eine Lastvorrichtung auf, die mit Source-Anschlüssen der MOS-Feldeffekttransistoren und mit der Versorgungsspannung verbunden ist.

Die Schaltung ist dabei derart ausgebildet, dass diese in dem Betriebsmodus und in dem Ruhemodus steuerbar ist. Dabei zeichnet sich der Ruhemodus mit einem gegenüber dem Betriebsmodus reduzierten Stromverbrauch aus.

Die Lastvorrichtung ist derart ausgebildet, dass ein im Ruhemodus durch die MOS-Feldeffekttransistoren und durch die Lastvorrichtung fließender Leckstrom einen Spannungsabfall über die Lastvorrichtung erzeugt.

Die im Folgenden beschriebenen Weiterbildungen beziehen sich sowohl auf die Schaltung als auch auf die Verwendung als auch auf das Verfahren zur Steuerung.

In einer bevorzugten Weiterbildung ist vorgesehen, dass am jedem Versorgungsspannungsanschluss im Betriebsmodus eine Betriebs-Versorgungsspannung für den Betrieb des CMOS-Schaltkreises bereitgestellt ist.

Gemäß einer vorteilhaften Weiterbildung ist die erste Lastvorrichtung einrichtet einen ersten Spannungsabfall über die erste Lastvorrichtung ausschließlich mittels eines Leckstroms zu erzeugen, wobei der Leckstrom durch den digitalen CMOS-Schaltkreis und durch die erste Lastvorrichtung fließt.

In einer anderen vorteilhaften Weiterbildung ist vorgesehen, dass die zweite Lastvorrichtung einrichtet ist einen zweiten Spannungsabfall über die zweite Lastvorrichtung ausschließlich mittels eines Leckstroms zu erzeugen, wobei der Leckstrom durch den digitalen CMOS-Schaltkreis und durch die zweite Lastvorrichtung fließt.

Gemäß einer Weiterbildung ist vorgesehen, dass die Schaltung NMOS-Transistoren und PMOS-Transistoren aufweist, die einen digitalen CMOS-Schaltkreis bilden. Die Schaltung weist dabei eine erste Lastvorrichtung auf, die mit den Source-Anschlüssen der NMOS-Transistoren und mit einer ersten Versorgungsspannung verbunden ist. Die Schaltung weist weiterhin eine zweite Lastvorrichtung auf, die mit den Source-Anschlüssen der PMOS-Feldeffekttransistoren und mit einer zweiten Versorgungsspannung verbunden ist. Vorzugsweise bewirkt ein Spannungsabfall über der ersten Lastvorrichtung und/oder der zweiten Lastvorrichtung ein gegenüber dem Body-Potenzial höheres Source-Potenzial der NMOS-Feldeffekttransistoren und/oder ein gegenüber dem Body-Potenzial niedrigeres Source-Potenzial der PMOS-Feldeffekttränsistoren.

Gemäß einer besonders bevorzugten Weiterbildung ist der digitale CMOS-Schaltkreis für einen Betriebsmodus und für einen Ruhemodus ausgebildet. In dem Betriebsmodus ist der digitale CMOS-Schaltkreis zur Ausführung verschiedener Betriebsfunktionen ausgebildet. Beispielsweise führt der digitale CMOS-Schaltkreis dabei Berechnungen durch, schreibt Informationen in Speicher beziehungsweise Register oder liest entsprechende Informationen aus Speicherzellen aus. Im Betriebsmodus ist ein Taktsignal an den digitalen CMOS-Schaltkreis anlegbar. Hingegen führt der digitale CMOS-Schaltkreis in dem Ruhemodus vorzugsweise keine Operationen aus.

Bevorzugt ist jedoch vorgesehen, dass im Ruhemodus alle digitalen Elemente wie Gatter oder Speicherelemente und dergleichen einen definierten Zustand aufweisen. Ein derartiger definierter Zustand ist eine logische Eins oder eine logische Null an dem Ausgang des jeweiligen Elementes. Der digitale CMOS-Schaltkreis kann dabei mit einem weiteren digitalen CMOS-Schaltkreis zusammenwirken, der im Ruhemodus von der ersten Versorgungsspannung und der zweiten Versorgungsspannung vollständig abgeschaltet ist und daher nicht definierte Zustände aufweisen kann.

In einer anderen besonders bevorzugten Weiterbildung weisen die erste Lastvorrichtung und die zweite Lastvorrichtung jeweils eine einstellbare Widerstandsvorrichtung auf. Eine derartige Widerstandsvorrichtung ist vorteilhafterweise ein schaltbarer Widerstand, wie beispielsweise ein ohmscher Widerstand, der mittels eines Transistors zu- und abschaltbar ist. Alternativ kann als schaltbarer Widerstand auch ein einstellbarer (aktiver) Widerstand in Form eines Feldeffekttransistors verwendet werden, dessen Drain-Source-Strecke zwischen (zumindest) zwei Widerstandswerten veränderbar ist. Beispielsweise ist eine kontinuierliche Veränderung des Widerstandswerts oder eine umschalten zwischen mehreren diskreten Widerstandswerten möglich.

Bevorzugt weist die einstellbare Widerstandsvorrichtung zumindest einen Feldeffekttransistor auf. Alternativ zu einer einstellbaren Widerstandsvorrichtung könnte als erste und/oder zweite Lastvorrichtung auch ein Bauelement verwendet werden, das im Ruhemodus aufgrund des geringen Leckstromes einen hohen Widerstandswert und im Betriebsmodus aufgrund des hohen Betriebsstromes einen signifikant geringeren Widerstandswert aufweist. In diesem Fall würde die erste und/oder zweite Lastvorrichtung ihren Widerstand selbstständig einstellen.

In einer anderen Weiterbildungsvariante ist vorgesehenen, dass die einstellbare Widerstandsvorrichtung zumindest in einem Ruhemodus einen nichtlinearen Widerstandswert aufweist. Demzufolge weicht die Stromspannungskennlinie der einstellbaren Widerstandsvorrichtung von einer Geraden ab. Vorzugsweise weist die Widerstandsvorrichtung einen Feldeffekttransistor auf, so dass der Widerstandswert durch die Kennlinie des Feldeffekttransistors gebildet ist, wobei ein Gate-Anschluss und ein Drain-Anschluss des Feldeffekttransistors miteinander leitend verbindbar oder verbunden sind. Um den Gate-Anschluss und den Drain-Anschluss des Feldeffekttransistors leitend miteinander zu verbinden, ist vorzugsweise ein weiterer Feldeffekttransistor vorgesehen, dessen Drain-Source-Strecke die Verbindung herstellt.

Die Erfindung bevorzugt weiterbildend ist vorgesehen, dass die einstellbare Widerstandsvorrichtung ein Widerstandselement und ein zu dem Widerstandselement parallel geschaltetes Schaltelement aufweist. Das Schaltelement ist beispielsweise ein Feldeffekttransistor. Das Widerstandselement ist beispielsweise ein ohmscher Widerstand oder ein einstellbarer (aktiver) Widerstand, dessen Widerstandswert beispielsweise durch seine Verschaltung fest eingestellt ist. Im Ruhemodus wirkt das Widerstandselement in Reihe zu dem digitalen CMOS-Schaltkreis, so dass ein Leckstrom durch den digitalen CMOS-Schaltkreis einen Spannungsabfall über dem Widerstandselement verursacht. Hingegen schließt das Schaltelement das Widerstandselement im Betriebsmodus kurz, so dass der Betriebsstrom über das Schaltelement fließt.

Gemäß einer besonders bevorzugten Weiterbildung weisen die erste und die zweite Lastvorrichtung im Ruhemodus einen größeren Widerstandswert auf als im Betriebsmodus. Sind mehrere Ruhemodi vorgesehen, kann in einer Weiterbildung der Erfindung der Widerstandswert den verschiedenen Ruhemodi jeweils angepasst werden.

In einer besonders bevorzugten Weiterbildung ist vorgesehen, dass der digitale Schaltkreis eine Anzahl von Speicherelementen und/oder eine Anzahl von Logikelementen aufweist. Derartige Speicherelemente sind beispielsweise Flipflops oder Latches oder dergleichen. Die Logikelemente sind beispielsweise Gatter oder dergleichen. Die Speicherelemente und die erste Lastvorrichtung und die zweite Lastvorrichtung sind dabei derart ausgebildet, dass die in den Speicherelementen enthaltene Information im Ruhemodus erhalten bleibt. Die Logikelemente und die erste Lastvorrichtung und die zweite Lastvorrichtung sind dabei derart ausgebildet, dass die Logikelemente im Ruhemodus definierte logische Zustände beibehalten.

Bevorzugt sind der digitale Schaltkreis insbesondere mit Speicherelementen und die erste und die zweite Lastvorrichtung in Reihe geschaltet. Dabei fließt der Leckstrom über die erste Lastvorrichtung und erzeugt an der ersten Lastvorrichtung einen ersten Spannungsabfall. Der Leckstrom fließt weiter durch den digitalen Schaltkreis und schließlich durch die zweite Lastvorrichtung und erzeugt dort ebenfalls einen zweiten Spannungsabfall. Die erste Lastvorrichtung und die zweite Lastvorrichtung sowie die Speicherelemente müssen dabei derart ausgebildet sein, dass die zur Verfügung stehenden Versorgungsspannungen abzüglich des Spannungsabfalls über die erste Lastvorrichtung und des Spannungsabfalls über die zweite Lastvorrichtung eine ausreichende Haltespannung über dem digitalen Schaltkreises erzeugen, wobei die Haltespannung ausreichend hoch ist, so dass die Speicherelemente einen definierten Zustand, also eine logische Eins oder eine logische Null beibehalten.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen:
- Fig. 1a: einen schematischen Querschnitt durch einen MOS-Feldeffekt-transistor,
- Fig. 1b: einen schematischen Verlauf einer Kennlinie eines MOS-Feldeffekttransistors,
- Fig. 2a: eine Prinzipschaltung einer Lastvorrichtung,
- Fig. 2b: eine weitere Prinzipschaltung einer Lastvorrichtung,
- Fig. 3: eine schematische Schaltung mit einem vereinfachten digitalen CMOS-Schaltkreis,
- Fig. 4a: eine schematische Darstellung einer Widerstandsvorrichtung, und
- Fig. 4b: eine schematische Darstellung einer alternativen Widerstandsvorrichtung.

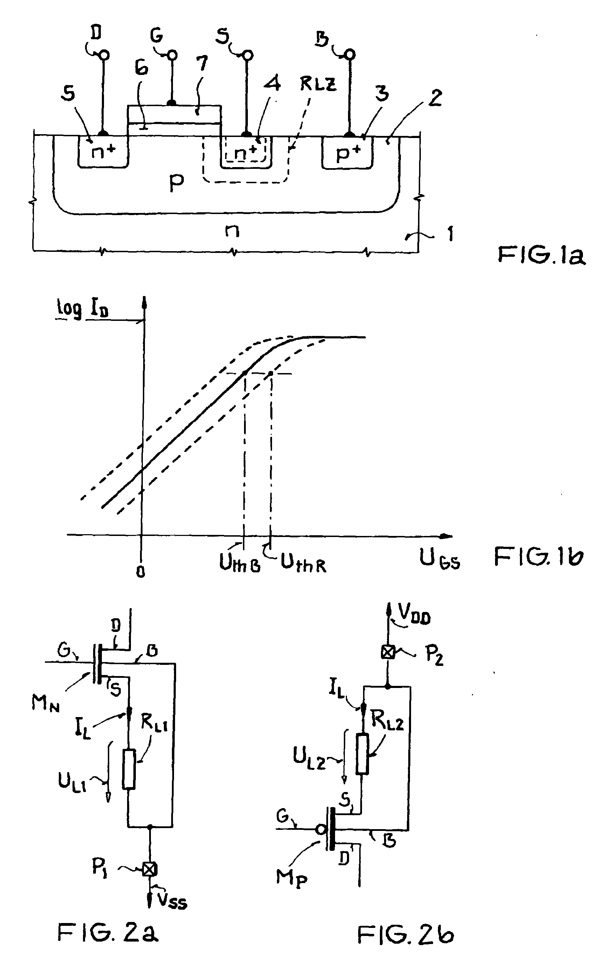

In Fig. 1 a ist ein MOS-Feldeffekttransistor in einer schematischen Schnittansicht dargestellt. Innerhalb eines n-dotierten Substrats 1 ist eine p-Wange 2 eingebracht, die das Body-Halbleitergebiet bildet. Zum Anschluss des Body-Halbleitergebietes 2 ist ein Anschluss-Halbleitergebiet 3 vorgesehen, das eine hohe p-Dotierung aufweist. Innerhalb des Body-Halbleitergebietes 2 sind ein Drain-Halbleitergebiet 5 und ein Source-Halbleitergebiet 4 angeordnet, die eine hohe n-Dotierung aufweisen.

Zwischen dem Drain-Gebiet 5 und dem Source-Gebiet 4 ist auf der Oberfläche ein Gate-Oxid 6 mit einer darauf angeordneten Gate-Elektrode 7 angeordnet. Unterhalb des Gate-Oxids 6 erstreckt sich zwischen dem Drain-Gebiet 5 und dem Source-Gebiet 4 p-dotiertes Halbleitermaterial des Body-Halbleitergebiets 2. Zum Anschluss des MOS-Feldeffekttransistors sind die Anschlüsse Drain D, Gate G, Source S und Body B vorgesehen. In einem Betriebsmodus kann an das Gate G eine gegenüber dem Body-Halbleitergebiet 2 positive Spannung angelegt werden, die einen Kanal unterhalb des Gate-Oxids 6 induziert. In diesem Fall leitet der MOS-Feldeffekttransistor und weist eine nieder-ohmige Drain-Source-Strecke auf. Wird das Gate G auf Source-Potential gelegt, sperrt der Transistor.

Im Ruhemodus sperrt entweder der in Fig. 1a dargestellte NMOS-Feldeffekttransistor oder ein mit diesem in Reihe geschalteter PMOS-Feldeffekttransistor. Für die folgende Betrachtung wird angenommen, dass der NMOS-Feldeffekttransistor, wie dieser in der Fig. 1a dargestellt ist, sperrt und somit den Leckstrom durch die Reihenschaltung aus PMOS-Feldeffekttransistor und diesem NMOS-Feldeffekttransistor festlegt. Dabei ist die Gate-Elektrode 7 auf demselben Potential wie die Source S. Weist auch der Body B dasselbe Potenzial wie die Source S auf, so liegen die Halbleitergebiete 3 und 4 auf demselben Potential-Niveau.

Der Leckstrom durch den MOS-Feldeffekttransistor gemäß Fig. 1a lässt sich in zwei Anteile aufteilen. Der kleinere Anteil wird durch Ladungsträgergeneration in einer um das Drain-Halbleitergebiet 5 sich ausbreitenden Raumladungszone - die in Fig. 1 nicht dargestellt ist - erzeugt. Der größere Leckstromanteil fließt jedoch unterhalb des Gate-Oxids 6 an der Grenzfläche zwischen Halbleitermaterial und Oxid vom Drain-Halbleitergebiet 5 in das Source-Halbleitergebiet 4.

Wird das Source-Potential im Halbleitergebiet 4 gegenüber dem Body-Potenzial im Halbleitergebiet 2 erhöht, bildet sich um das Halbleitergebiet 4 der Source S eine Raumladungszone RLZ, die sich auch unter das Gate-Oxid 6 unterhalb der Gate-Elektrode 7 im Body-Halbleitergebiet 2 erstreckt. Durch zunehmenden Spannungsabfall zwischen Body B und Source S wird dabei die Raumladungszone RLZ unter dem Gate-Oxid 6 größer.

Nach Abzug der Löcher zum Body-Anschluss-Halbleitergebiet 3 steigt damit die Zahl der festen Ladungen (E-lonen) an. Für Ladungsneutralität sinkt demnach in einem Bereich der Raumladungszone RLZ unterhalb des Gate-Oxids 6 die Ladung für die gleiche Gate-Source-Spannung. Dieses wird auch als Body-Effekt bezeichnet.

In Fig. 1b ist dargestellt, dass der Body-Effekt eine Erhöhung der Schwellspannung Uₜₕ von einem Schwellspannungswert im Betriebsmodus U_{thB} zu einem Schwellspannungswert im Ruhemodus U_{thR} bewirkt. Weiterhin ist in der Fig. 1b eine Kennlinie für den logarithmischen Wert des Drain-Stroms I_{D} bezüglich der Gate-Spannung U_{GS} dargestellt. Dabei ist es wünschenswert, dass im Betriebsmodus die Schwellspannung U_{thB} nicht erhöht wird. Hingegen soll im Ruhemodus bei einer Gate-Source-Spannung von 0 Volt der Drain-Strom I_{D} deutlich reduziert sein.

Fig. 2a zeigt das Grundprinzip einer Lastvorrichtung für einen Leckstrom durch einen NMOS-Transistor MN entsprechend dem NMOS-Transistor der Fig. 1 a. Dabei ist der Source-Anschluss S des NMOS-Feldeffekttransistors MN mit einer Lastvorrichtung RL1 verbunden. Diese Lastvorrichtung RL1 ist zudem mit einer Versorgungsspannung VSS über einen Anschluss P1 verbunden. Der Anschluss P1 ist beispielsweise eine PAD-Struktur des Halbleiterschaltkreises. Auch der Body-Anschluss B des NMOS-Feldeffekttransistors MN ist mit der Versorgungsspannung VSS verbunden.

Der über den Body-Anschluss B fließende Leckstrom wird in diesem Ausführungsbeispiel vernachlässigt, da er von dem Leckstrom der Source S, die auch durch die Lastvorrichtung RL1 fließt, signifikant überstiegen wird. Die Lastvorrichtung RL1 ist beispielsweise ein Widerstand. Der Leckstrom IL, der durch die Lastvorrichtung RL1 fließt, erzeugt dabei einen Spannungsabfall UL1 über der Lastvorrichtung RL1. Der Spannungsabfall UL1 über der Lastvorrichtung RL1 erzeugt demnach zwei unterschiedliche Potentiale am Body-Anschluss B und am Source-Anschluss S des NMOS-Feldeffekttransistors MN. Wie in der Fig. 1a bereits erläutert, erzeugt diese Potential-Differenz zwischen dem Source-Anschluss S und dem Body-Anschluss B eine Raumladungszone um das Source-Halbleitergebiet 4.

Durch diese Anordnung kann für den Ruhemodus der überraschende Effekt erzielt werden, dass der Leckstrom IL durch die Source S in Abhängigkeit von der Geometrie des NMOS-Feldeffekttransistors MN und der erzeugten Potential-Differenz zwischen Source S und Body B um bis zu 80 % reduziert wird. Das Ausführungsbeispiel der Fig. 2a ist dabei nur schematisch, da für eine ausreichende Potential-Differenz zwischen Source S und Body B eine Summation einer Vielzahl von Leckströmen einer großen Vielzahl von NMOS-Feldeffekttransistoren erforderlich ist, wobei Einzelleckströme beispielsweise in einem Stromknoten summiert werden, der mit der Lastvorrichtung RL1 leitend verbunden ist.

Fig. 2b zeigt eine komplementäre Version einer Lastvorrichtung RL2 für den Leckstrom IL durch die Source S eines PMOS-Feldeffekttransistor MP. Wiederum ist die Lastvorrichtung RL2 mit der Source S des Feldeffekttransistors MP und einer Versorgungsspannung VDD verbunden. Zudem ist der Body-Anschluss des PMOS-Feldeffekttransistors MP mit derselben Versorgungsspannung VDD verbunden. Der Leckstrom IL durch die Source S bewirkt wiederum einen Spannungsabfall UL2 an der Lastvorrichtung RL2, der zu einer Potential-Differenz zwischen Source S und Body B führt. Auch bei dem PMOS-Feldeffekttransistor MP bildet sich dabei um sein (p-dotiertes) Source-Halbleitergebiet eine Raumladungszone, die eine Reduktion des Leckstromes um beispielsweise 80% ermöglicht.

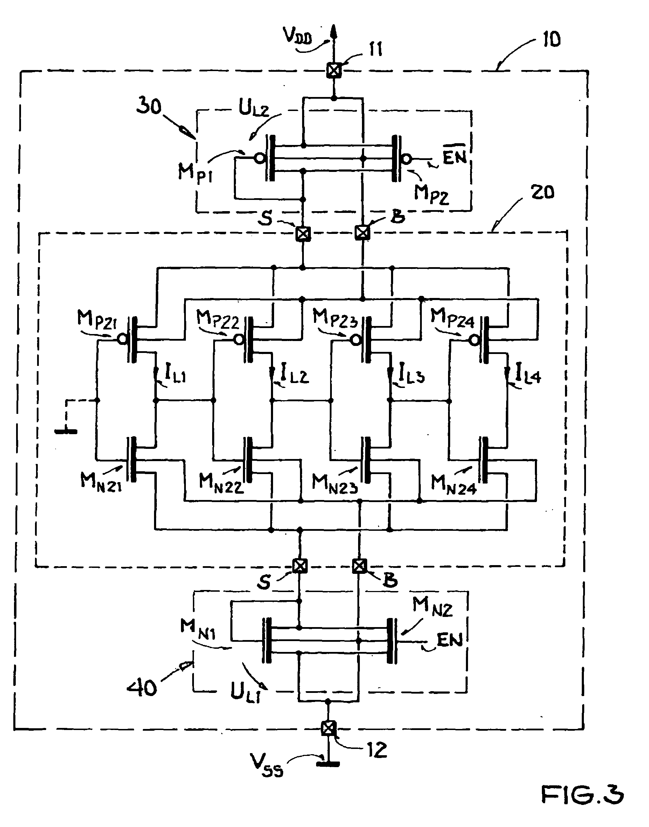

Ein schematisches Ausführungsbeispiel für eine Schaltung 10 mit einem digitalen CMOS-Schaltkreis 20 und einer ersten Lastvorrichtung 40 und einer zweiten Lastvorrichtung 30 ist in der Fig. 3 schematisch dargestellt. Die erste Lastvorrichtung 40 ist mit allen Source-Anschlüssen S und allen Body-Anschlüssen B der NMOS-Feldeffekttransistoren MN21, MN22, MN23 und MN24 des digitalen CMOS-Schaltkreises 20 verbunden. Weiterhin ist die erste Lastvorrichtung 40 über das Pad 12 mit einer ersten Versorgungsspannung VSS verbunden, die kleiner ist als eine zweite Versorgungsspannung VDD, die mit dem Pad 11 verbunden ist. Beispielsweise ist die erste Versorgungsspannung VSS eine negative Spannung oder eine Masse. Die erste Versorgungsspannung VSS und die zweite Versorgungsspannung VDD sind zugleich für einen Betrieb CMOS-Schaltkreises 20 vorgesehen und an denselben Anschlüssen 11, 12 angelegt. Beispielsweise wird an den Pads 11 und 12 eine Versorgungsspannungsdifferenz von beispielsweise 3,3 V für den Betrieb des CMOS-Schaltkreises 20 angelegt. Die Versorgungsspannungsdifferenz ist für den Ruhemodus im Rahmen der Genauigkeit einer die Versorgungsspannungsdifferenz bereitstellenden Spannungsquellenvorrichtung gleich.

Die zweite Lastvorrichtung 30 ist hingegen mit der zweiten Versorgungsspannung VDD über das Pad 11 verbunden. Die zweite Versorgungsspannung VDD ist beispielsweise eine positive Versorgungsspannung. Weiterhin ist die zweite Lastvorrichtung 30 mit allen Source-Anschlüssen S der PMOS-Feldeffekttransistoren MP21, MP22, MP23 und MP24 des CMOS-Schaltkreises 20 verbunden. Zudem ist die zweite Lastvorrichtung 30 mit allen Body-Anschlüssen B der PMOS-Feldeffekttransistoren MP21, MP22, MP23 und MP24 des CMOS-Schaltkreises 20 verbunden.

Die PMOS-Feldeffekttransistoren MP21, MP22, MP23 und MP24 weisen Body-Anschlüsse B auf, die unmittelbar mit der zweiten Versorgungsspannung VDD verbunden sind. Die NMOS-Feldeffekttransistoren MN21, MN22, MN23 und MN24 weisen einen Body-Anschluss B auf, der unmittelbar mit der ersten Versorgungsspannung VSS verbunden ist.

Der NMOS-Feldeffekttransistor MN1 der ersten Lastvorrichtung 40 wirkt dabei entsprechend dem in der Fig. 2a dargestellten Widerstand RL1 als Lastvorrichtung. Dabei ist das Gate des NMOS-Feldeffekttransistors MN1 der ersten Lastvorrichtung 40 mit dem Drain-Anschluss des NMOS-Feldeffekttransistors MN1 der ersten Lastvorrichtung 40 verbunden. Hierdurch weist der NMOS-Feldeffekttransistor MN1 eine nichtlineare Kennlinie auf, die bereits bei kleinen Strömen durch den NMOS-Feldeffekttransistor MN1 einen Spannungsabfall >0,1 Volt bewirkt. Im Ausführungsbeispiel der Fig. 3 fließt in einem Ruhemodus ausschließlich ein Leckstrom durch den NMOS-Feldeffekttransistor MN1 der ersten Lastvorrichtung 40, wobei der Leckstrom ebenfalls durch den CMOS-Schaltkreis 20 fließt. Ausschließlich dieser Leckstrom erzeugt dabei an der ersten Lastvorrichtung 40 den Spannungsabfall UL1. Hierdurch wird der vorteilhafte Effekt erzielt, dass der Spannungsabfall UL1 zur Reduktion des Leckstromes vom Leckstrom selbst erzeugt wird, so dass kein zusätzlicher Strom zur Spannungserzeugung benötigt wird.

Dieser Spannungsabfall UL1 ist im Ruhemodus dafür verantwortlich, dass der Leckstrom durch den digitalen CMOS-Schaltkreis 20, und somit durch die NMOS-Feldeffekttransistoren MN21, MN22, MN23 und MN24 des digitalen CMOS-Schaltkreises 20, durch die Potential-Differenz zwischen dem Source-Anschluss S und dem Body-Anschluss B signifikant reduziert wird. Die Potenzial-Differenz wird dabei durch den Spannungsabfall UL1 über dem NMOS-Feldeffekttransistor MN1 der ersten Lastvorrichtung 40 bewirkt.

Dieser Spannungsabfall UL1 ist hingegen im Betriebsmodus nicht erwünscht, so dass die erste Lastvorrichtung 40 einen weiteren NMOS-Feldeffekttransistor MN2 aufweist, der als Schalterelement wirkt und im eingeschalteten Zustand die Drain-Source-Strecke des als Widerstandselement wirkenden NMOS-Feldeffekttransistor MN1 kurzschließt. Hierzu wird eine logische Eins bzw. ein High-Signal an dem Steuereingang EN des als Schaltelement wirkenden NMOS-Feldeffekttransistors MN2 angelegt.

Entsprechend zur ersten Lastvorrichtung 40 ist die zweite Lastvorrichtung 30 komplementär ausgebildet. Der als Widerstandselement wirkende PMOS-Feldeffekttransistor MP1 erzeugt dabei im Ruhemodus einen Spannungsabfall UL2, der das Potential am Body B gegenüber dem Potential an der Source S der PMOS-Feldeffekttransistoren MP21, MP22, MP23 und MP24 der digitalen CMOS-Schaftung erhöht. Im Ausführungsbeispiel der Fig. 3 fließt in einem Ruhemodus ausschließlich ein Leckstrom durch den PMOS-Feldeffekttransistor MP1 der zweiten Lastvorrichtung 30, wobei der Leckstrom ebenfalls durch den CMOS-Schaltkreis 20 fließt. Ausschließlich dieser Leckstrom erzeugt dabei an der zweiten Lastvorrichtung 30 den Spannungsabfall UL2. Hierdurch wird der vorteilhafte Effekt erzielt, dass der Spannungsabfall UL2 zur Reduktion des Leckstromes vom Leckstrom selbst erzeugt wird, so dass kein zusätzlicher Strom zur Spannungserzeugung benötigt wird.

Im schematischen Ausführungsbeispiel der Fig. 3 sperren beispielsweise die PMOS-Transistoren MP22 und MP24, so dass der Strom durch den als Widerstandselement wirkenden PMOS-Transistor MP1 der zweiten Lastvorrichtung 30 durch die Summe der Leckströme IL2 und IL4 bestimmt ist. Hingegen bestimmen die Leckströme IL1 und 1L2 durch die NMOS-Transistoren MN21 und MN23 den Strom durch den als Widerstandselement wirkenden NMOS-Feldeffekttransistor MN1 der ersten Lastvorrichtung 40.

Für den Betriebsmodus wird ein Steuersignal an den als Schalterelement wirkenden NMOS-Feldeffekttransistor MN2 der ersten Lastvorrichtung 40 und ein invertiertes Steuersignal an den Steuereingang EN des als Schalterelement wirkenden PMOS-Feldeffekttransistors MP2 der zweiten Lastvorrichtung 30 angelegt, so dass die Widerstandselemente MP1 und MN1 jeweils kurzgeschlossen werden.

Die im Ruhemodus entstehenden Spannungsabfälle UL1 und UL2 über den NMOS-Feldeffekttransistor MN1 respektive dem PMOS-Feldeffekttransistor MP1 müssen dabei derart ausgelegt werden, dass der resultierende Spannungsabfall über den digitalen CMOS-Schaltkreis 20 ausreichend hoch ist, so dass die High-Pegel und Low-Pegel innerhalb des digitalen CMOS-Schaltkreises 20 im Ruhemodus sicher definiert sind.

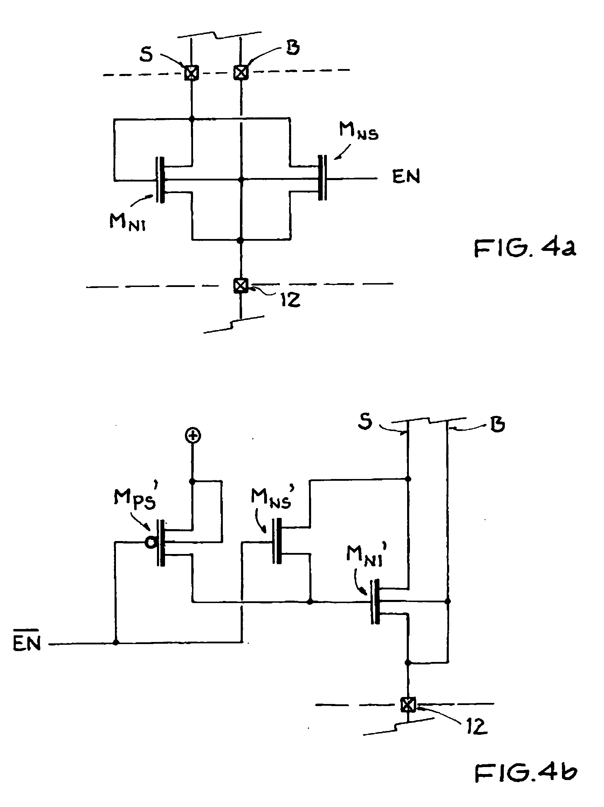

Fig. 4a zeigt in einer schematischen Darstellung ein erstes Ausführungsbeispiel einer Lastvorrichtung mit NMOS-Feldeffekttransistoren MN1 und MNS, wie dies analog in der Fig. 3 verwendet wird. Hingegen zeigt Fig. 4b ein alternatives Ausführungsbeispiel einer Lastvorrichtung mit einem NMOS-Feldeffekttransistor MN1' als einstellbare Widerstandsvorrichtung.

Im Gegensatz zum Ausführungsbeispiel der Fig. 4a sind im Ausführungsbeispiel der Fig. 4b der Gate-Anschluss des NMOS-Feldeffekttransistors MN1' und der Drain-Anschluss des NMOS-Feldeffekttransistors MN1' nicht direkt sondern über einen Schalttransistor MNS' verbunden. Weiterhin ist der Gate-Anschluss des als einstellbare Widerstandsvorrichtung wirkenden NMOS-Feldeffekttransistors MN1' über einen weiteren Schalttransistor MPS' mit der positiven Versorgungsspannung verbunden.

Diese Schaltungskonfiguration der Abbildung 4b bewirkt, dass bei einem Low-Signal am Steuereingang EN die positive Versorgungsspannung mittels des weiteren Halbleiterschalters MPS' auf die Gate-Elektrode des als einstellbare Widerstandsvorrichtung wirkenden NMOS-Feldeffekttransistors MN1 geschaltet wird und diesen in einen nieder-ohmigen Zustand schaltet, so dass die Source-Anschlüsse des digitalen CMOS-Schaltkreises 20 unmittelbar mit der Versorgungsspannung VSS im Betriebsmodus verbunden werden. Wird hingegen im Ruhemodus ein High-Signal an den Steuereingang EN angelegt, schaltet der Schalttransistor MNS' durch, während der weitere Schalttransistor MPS' sperrt, so dass durch den Schalttransistor MNS' der Drain-Anschluss und Gate-Anschluss des als einstellbare Widerstandsvorrichtung wirkenden NMOS-Feldeffekttransistors MN1' miteinander verbunden werden.

Die Erfindung ist aber nicht auf die dargestellten Ausgestaltungsvarianten der Fig. 1a bis 4b beschränkt. Beispielsweise ist es möglich, anstelle des CMOS-Schaltkreises einen anderen digitalen Schaltkreis-Typ mit entsprechend geringem Ruhestrom zu verwenden. Auch kann ein digitaler Schaltkreis mit ausschließlich NMOS-Transistoren oder ausschließlich PMOS-Transistoren vorgesehen sein. Anstelle des in Fig. 3 dargestellten digitalen CMOS-Schaltkreises 20 kann ein Schaltkreis mit einer viel größeren Anzahl von logischen Funktionen, Gattern und Speicherelementen wie Flipflops oder Latches verwendet werden.

Bezugszeichenliste
- 1: Substrat
- 2: P-Wanne, Body-Gebiet
- 3: Body-Anschluss-Gebiet
- 4: Source-Gebiet
- 5: Drain-Gebiet
- 6: Gate-Oxid
- 7: Gate-Elektrode
- 10: Schaltung
- 11, 12: Anschluss
- 20: digitaler CMOS-Schaltkreis
- 30, 40: Lastvorrichtung
- MN, MN1" MN2, MN1', MNS,:
- MNS', MN21, MN22, MN23, MN24: NMOS-Feldeffekttransistor
- MP, MP1, MP2, MPS', MP21,:
- MP22, MP23, MP24: PMOS-Feldeffekttransistor
- G: Gate-Anschluss
- S: Source-Anschluss
- D: Drain-Anschluss
- B: Body-Anschluss
- EN: Steuereingang
- RL1, RL2: Widerstandsvorrichtung, Widerstand
- RLZ: Raumladungszone
- ID: Drainstrom
- IL: Leckstrom
- UthB, UthR: Schwellspannung
- UGS: Gate-Source-Spannung
- UL1, UL2: Spannungsabfall
- VDD: positive Versorgungsspannung
- VSS: Masse, negative Versorgungsspannung

## Patentansprüche

1. Schaltung (10),
- mit einem digitalen CMOS-Schaltkreis (20) mit NMOS-Feldeffekttransistoren (MN21, MN22, MN23, MN24) und mit PMOS-Feldeffekttransistoren (MP21, MP22, MP23, MP24),
- mit einer ersten Lastvorrichtung (40), wobei Source-Anschlüsse (S) der NMOS-Feldeffekttransistoren (MN21, MN22, MN23, MN24) des digitalen CMOS-Schaltkreises (20) über die erste Lastvorrichtung (40) mit einer ersten Versorgungsspannung (VSS) verbunden sind, und
- mit einer zweiten Lastvorrichtung (30), wobei Source-Anschlüsse (S) der PMOS-Feldeffekttransistoren (MP21, MP22, MP23, MP24) des digitalen CMOS-Schaltkreises (20) über die zweite Lastvorrichtung (30) mit einer zweiten Versorgungsspannung (VDD) verbunden sind,
- bei der Body-Anschlüsse (B) der NMOS-Feldeffekttransistoren (MN21, MN22, MN23, MN24) des digitalen CMOS-Schaltkreises (20) unmittelbar mit der ersten Versorgungsspannung (VSS) verbunden sind,
- bei der Body-Anschlüsse (B) der PMOS-Feldeffekttransistoren (MP21, MP22, MP23, MP24) des digitalen CMOS-Schaltkreises (20) unmittelbar mit der zweiten Versorgungsspannung (VDD) verbunden sind.

2. Schaltung nach Anspruch 1,
- bei der die erste Lastvorrichtung (40) verbunden und einrichtet ist einen ersten Spannungsabfall über die erste Lastvorrichtung (40) ausschließlich mittels eines Leckstroms zu erzeugen, wobei der Leckstrom durch den digitalen CMOS-Schaltkreis (20) und durch die erste Lastvorrichtung (40) fließt.

3. Schaltung nach einem der vorhergehenden Ansprüche,
- bei der die zweite Lastvorrichtung (30) verbunden und einrichtet ist einen zweiten Spannungsabfall über die zweite Lastvorrichtung (30) ausschließlich mittels eines Leckstroms zu erzeugen, wobei der Leckstrom durch den digitalen CMOS-Schaltkreis (20) und durch die zweite Lastvorrichtung (30) fließt.

4. Schaltung nach einem der vorhergehenden Ansprüche,
- bei der der digitale CMOS-Schaltkreis (20) für einen Betriebsmodus und für einen Ruhemodus ausgebildet ist.

5. Schaltung nach einem der vorhergehenden Ansprüche,
- bei der die erste Lastvorrichtung (40) und die zweite Lastvorrichtung (30) jeweils eine einstellbare Widerstandvorrichtung (MP1, MP2, MN1, MN2), insbesondere einen schaltbaren Widerstand (MP1, MP2, MN1, MN2) aufweist.

6. Schaltung nach Anspruch 5,
- bei der die einstellbare Widerstandsvorrichtung (MP1, MP2, MN1, MN2) zumindest einen Feldeffekttransistor (MP1, MP2, MN1, MN2) aufweist.

7. Schaltung nach einem der Ansprüche 5 oder 6,
- bei der die einstellbare Widerstandsvorrichtung (MP1, MP2, MN1, MN2) zumindest in einem Ruhemodus einen nichtlinearen Widerstandswert aufweist, der insbesondere durch einen Feldeffekttransistor (MP1, MN1), dessen Gate-Anschluss und Drain-Anschluss miteinander leitend verbindbar oder verbunden sind, gebildet ist.

8. Schaltung nach einem der Ansprüche 5 bis 7,
- bei der die einstellbare Widerstandsvorrichtung (MP1, MP2, MN1, MN2) ein Widerstandselement (MP1, MN1) und ein parallel geschaltetes Schaltelement (MP2, MN2) aufweist, das das Widerstandselement (MP1, MN1) im Betriebsmodus kurzschließt.

9. Schaltung nach einem der Ansprüche 4 bis 8,
- bei der die erste Lastvorrichtung (40) und die zweite Lastvorrichtung (30) im Ruhemodus einen größeren Widerstandswert aufweisen als im Betriebsmodus.

10. Schaltung nach einem der vorhergehenden Ansprüche,
- bei der der digitale Schaltkreis (20) eine Anzahl von Speicherelementen und/oder eine Anzahl von Logikelementen aufweist, und
- bei der die erste Lastvorrichtung (40) und die zweite Lastvorrichtung (30) und die Speicherelemente und/oder Logikelemente derart ausgebildet sind, dass die in den Speicherelementen enthaltene Information und/oder die logischen Zustände der Logikelemente im Ruhemodus erhalten bleibt.

11. Verfahren für eine Schaltung (10) mit MOS-Feldeffekttransistoren (MP21, MP22, MP23, MP24, MN21, MN22, MN23, MN24) zur Steuerung der Schaltung (10) in einen Betriebsmodus und in einen Ruhemodus mit gegenüber dem Betriebsmodus reduziertem Stromverbrauch,
- bei dem in dem Betriebsmodus eine mit Source-Anschlüssen (S) der MOS-Feldeffekttransistoren (MP21, MP22, MP23, MP24, MN21, MN22, MN23, MN24) verbundene Lastvorrichtung (MP1, MP2, MN1, MN2) in einen niederohmigen Zustand gesteuert wird,
- bei dem in dem Ruhemodus die Lastvorrichtung (30, 40) in einen Zustand mit höherem Widerstandswert derart gesteuert wird, dass ein im Ruhemodus durch die MOS-Feldeffekttransistoren (MP21, MP22, MP23, MP24, MN21, MN22, MN23, MN24) und durch die Lastvorrichtung (30, 40) fließender Leckstrom (IL) einen Spannungsabfall (UL1, UL2) über der Lastvorrichtung (30, 40) erzeugt.

12. Verwendung einer mit Source-Anschlüssen (S) von MOS-Feldeffekttransistoren (MP21, MP22, MP23, MP24, MN21, MN22, MN23, MN24) einer Schaltung (10) verbundenen Lastvorrichtung (30, 40) zur Erzeugung einer Body-Source-Spannung der MOS-Feldeffektransistoren (MP21, MP22, MP23, MP24, MN21, MN22, MN23, MN24) in einem Ruhemodus der Schaltung (10) mittels eines durch die MOS-Feldeffekttransistoren (MP21, MP22, MP23, MP24, MN21, MN22, MN23, MN24) und durch die Lastvorrichtung (30, 40) fließenden Leckstromes (IL), der einen, die Body-Source-Spannung bildenden Spannungsabfall (UL1, UL2) an der Lastvorrichtung (30, 40) erzeugt.
